# EUROPEAN PATENT APPLICATION

(11) **EP 2 669 692 A1**
(43) Date of publication of application: **04.12.2013**
(21) Application number: 11856427.7
(22) Date of filing: 17.01.2011
(51) Int. Cl.: G01R 31/02

(54) **EARTH DEVICE**

(71) Applicant: Nitto Denko Corporation, Osaka 567-8680 (JP)
(72) Inventor: UEKI, Shinya, Ibaraki-shi Osaka 567-8680 (JP); TSUJI, Yasuo, Ibaraki-shi Osaka 567-8680 (JP)
(74) Representative: HOFFMANN EITLE
(86) International application number: PCT/JP2011/050618
(87) International publication number: WO 2012/098629

(57) **Abstract**

An earth device is an earth device for earthing an object to be earthed. The earth device includes an earth-side wire, a detection-side wire which is normally out of conduction with the earth-side wire, an attachment member provided on one end portion of each of the earth-side wire and the detection-side wire and attached to the object to be earthed to provide conduction between the earth-side wire and the detection-side wire, an earth member for earthing provided on the other end portion of each of the earth-side wire and the detection-side wire, and a detection means connected to the detection-side wire to detect conduction in the detection-side wire.

## Description

### TECHNICAL FIELD

The present invention relates to an earth device for earthing an object to be earthed.

### BACKGROUND ART

To a container for storing a volatile organic solvent or a device to which a high voltage is applied, an earth device for preventing charging and releasing electric charge may be connected.

By earthing, when, e.g., an organic solvent is handled, it is possible to prevent the charging of a container, the resulting generation of static electricity, and the resulting ignition of the organic solvent, and it is possible to, e.g., release electric charge from a device to which a high voltage is applied and prevent an electrical shock.

As such an earth device, a grounding device has been proposed which includes, e.g., a ground rod to be grounded via an earth wire, an auxiliary electrode coupled to the ground rod via an insulating material and also grounded via a lead wire, and an indicator light provided in the middle of the lead wire and in which not only the ground rod, but also the auxiliary electrode is brought into contact with a high-voltage box to form a closed loop which extending from and returning to a power source through the indicator light, the lead wire, the auxiliary electrode, the high-voltage box, the ground rod, the earth wire, and a ground potential portion to turn on the indicator light (see, e.g., Patent Document 1 shown below).

In the grounding device, when the high-voltage box is not grounded by the ground rod, the indicator light is turned off. Accordingly, it is possible to easily recognize that the high-voltage box is grounded by the ground rod.

### Prior Art Document

### Patent Document

Patent Document 1: Japanese Unexamined Patent No. Hei 9-219226

### SUMMARY OF THE INVENTION

### PROBLEMS TO BE SOLVED BY THE INVENTION

In the grounding device described in Patent Document shown 1 above, in order to recognize that the high-voltage box is grounded by the ground rod, both of the ground rod and the auxiliary electrode need to be in contact with the high-voltage box, but the ground rod and the auxiliary electrode are arranged in parallel and spaced-apart relation.

This may result in the case where, due to interference by an obstacle or the like, only either one of the ground rod and the auxiliary electrode comes in contact with the high-voltage box, while the other does not. This causes the problem that, when, e.g., the ground rod comes in contact with the high-voltage box and the auxiliary electrode does not, even though the high-voltage box is grounded by the ground rod, the indicator light is turned off so that it is impossible to recognize the grounding of the high-voltage box by the ground rod.

An object of the present invention is to provide an earth device which can reliably detect that an object to be earthed is earthed.

### MEANS FOR SOLVING THE PROBLEM

An earth device of the present invention includes an earth-side wire, a detection-side wire which is normally out of conduction with the earth-side wire, an attachment member provided on one end portion of each of the earth-side wire and the detection-side wire and attached to the object to be earthed to provide conduction between the earth-side wire and the detection-side wire, an earth member for earthing provided on the other end portion of each of the earth-side wire and the detection-side wire, and a detection means connected to the detection-side wire to detect conduction in the detection-side wire.

The earth device includes the earth-side wire, and the detection-side wire including the detection means in a normally non-conducting state. The earth-side wire and the detection-side wire are brought into conduction by the attachment of the attachment member provided on one end portion of each of the earth-side wire and the detection-side wire to the object to be earthed. In addition, the earth member is provided on the other end portion of each of the earth-side wire and the detection-side wire.

Thus, the attachment of the attachment member to the object to be earthed ensures conduction between the object to be earthed and each of the earth-side wire and the detection-side wire.

As a result, a series circuit is formed which extends from the detection-side wire and successively passes through the object to be earthed and the earth-side wire to reach the earth member. By detecting the conduction in the detection-side wire with the detection means, it is possible to reliably detect that the object to be earthed is earthed by the earth-side wire.

In the earth device of the present invention, it is preferable that the attachment member includes a first conductive member connected to one end portion of the earth-side wire, a second conductive member connected to one end portion of the detection-side wire so as to be disposed to face the first conductive member in spaced-apart relation thereto and brought into conduction with the first conductive member when the attachment member is attached to the object to be earthed, and an insulating member which normally provides insulation between the first conductive member and the second conductive member, and the attachment member is attached to the object to be earthed so as to hold the object to be earthed between the first conductive member and the second conductive member to have a position thereof fixed to that of the object to be earthed.

In the earth device, the attachment member is attached to the object to be earthed so as to hold the object to be earthed between the first conductive member and the second member to have the position thereof fixed to that of the object to be earthed.

Accordingly, when the attachment member is attached to the object to be earthed, it is possible to fix the positions of the first conductive member and the second conductive member on both sides of substantially the same portion of the object to be earthed.

In addition, the insulating member normally provides insulation between the first conductive member and the second conductive member.

Accordingly, when the attachment member is attached to the object to be earthed, conduction is reliably provided between the first conductive member and the second conductive member via the object to be earthed.

As a result, it is possible to more reliably detect that the object to be earthed is earthed by the earth-side wire.

In the earth device of the present invention, it is preferable that the first conductive member is a first holding member for holding the object to be earthed from one side, the second conductive member is a second holding member for holding the object to be earthed from the other side, and the insulating member is a support member for supporting the first holding member and the second holding member rotatably around the same axis.

In the earth device, it is possible to allow the first holding member to hold the object to be earthed from one side and allow the second holding member to hold the object to be earthed from the other side.

Therefore, it is possible to reliably hold the object to be earthed between the first holding member and the second holding member.

In the earth device of the present invention, it is preferable that the detection means includes an indicator light which is turned on upon detecting the conduction in the detection-side wire.

In the earth device, it is possible to recognize that the detection means has detected the conduction in the detection-side wire from the turning on of the indicator light.

In the earth device of the present invention, it is preferable that the detection means includes a detection sound generator for generating a detection sound upon detecting the conduction in the detection-side wire.

In the earth device, it is possible to recognize that the detection means has detected the conduction in the detection-side wire from the detection sound from the detection sound generator.

### EFFECT OF THE INVENTION

With the earth device of the present invention, it is possible to reliably detect that the object to be earthed is earthed by the earth-side wire.

### BRIEF DESCRIPTION OF THE DRAWINGS

FIG. 1 is a schematic structural view showing an earth wire as an example of the earth device of the present invention;
FIG. 2 is an enlarged view of the attachment-side clip of the earth wire shown in FIG. 1;
FIG. 3 is an enlarged view of the earth-side clip of the earth wire shown in FIG. 1; and
FIG. 4 is a circuit diagram for illustrating earthing by the earth wire shown in FIG. 1.

### EMBODIMENT OF THE INVENTION

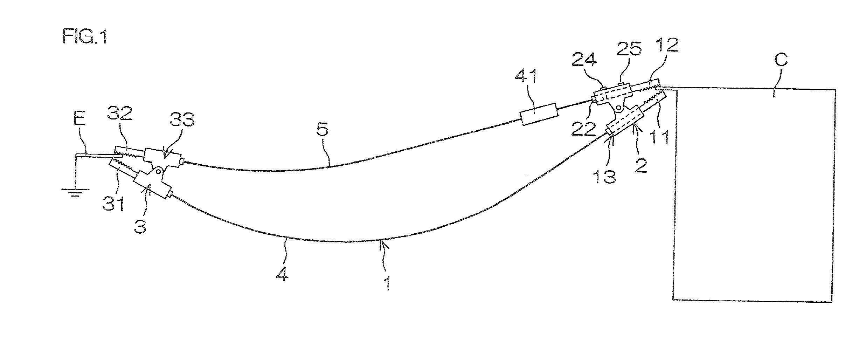

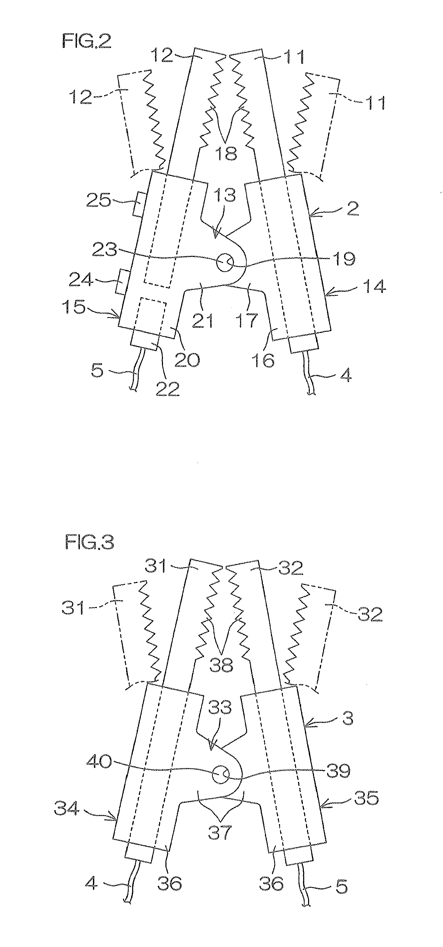

FIG. 1 is a schematic structural view showing an earth wire as an example of the earth device of the present invention. FIG. 2 is an enlarged view of the attachment-side clip of the earth wire shown in FIG. 1. FIG. 3 is an enlarged view of the earth-side clip of the earth wire shown in FIG. 1.

As shown in FIG. 1, an earth wire 1 is a cable for earthing a container C made of metal for containing a volatile organic solvent or the like. The earth wire 1 has a one-side end portion (one end portion, which similarly applies to the following) thereof connected to the container as an example of an object to be earthed and an other-side end portion (the other end portion, which similarly applies to the following) thereof connected to an earth-potential member E such as a steel pole.

The earth wire 1 includes an attachment-side clip 2 as an example of an attachment member, an earth-side clip 3 as an example of an earth member, an earth-side wire 4, and a detection-side wire 5.

The attachment-side clip 2 is provided on one end portion of the earth wire 1.

As shown in FIG. 2, the attachment-side clip 2 includes a first holding member 11 as a first conductive member, a second holding member 12 as a second conductive member disposed to face the first holding member 11 in spaced-apart relation thereto, and a supporting member 13 as an example of an insulating member.

The first holding member 11 is formed of a conductive material such as metal into a rod shape (generally U-shape in cross section) extending in a longitudinal direction (direction extending to one side and to the other side, which similarly applies to the following). One longitudinal end portion of the first holding member 11 has an indented non-slip portion 18 formed on the inner surface thereof in a facing direction (direction in which the first holding member 11 and the second facing member 12 face each other, which similarly applies to the following).

The second holding member 12 is formed of a conductive material such as metal into a rod shape (generally U-shape in cross section) extending in the longitudinal direction and shorter than the first holding member 11. One longitudinal end portion of the second holding member 12 has the indented non-slip portion 18 formed on the inner surface thereof in the facing direction.

The supporting member 13 includes a first supporting member 14 and a second supporting member 15.

The first supporting member 14 is made of an insulating resin and integrally includes a first covering portion 16 and a first coupling portion 17.

The first covering portion 16 is formed in a generally cylindrical shape extending along the longitudinal direction, and the other longitudinal end portion of the first holding member 11 is inserted in the first covering portion 16 to extend therethrough. As a result, the other longitudinal end portion of the first holding member 11 is covered with the first covering portion 16.

The first coupling portion 17 is formed in a generally triangular flat plate shape having a curved top portion and projects inward in the facing direction from the inner surface of the first covering portion 16 in the facing direction. The first coupling portion 17 has a through hole 19 formed to extend therethrough along a widthwise direction (direction perpendicular to each of the longitudinal direction and the facing direction, which similarly applies to the following).

The second supporting member 15 is made of an insulating resin, similarly to the first supporting member 14, and integrally includes a second covering portion 20 and a second coupling portion 21.

The second covering portion 20 is formed in a generally cylindrical shape extending along the longitudinal direction. In one longitudinal end portion of the second covering portion 20, the other longitudinal end portion of the second holding member 12 is inserted. As a result, the other longitudinal end portion of the second holding member 11 is covered with the second covering portion 20.

The second coupling portion 21 is formed in a generally triangular flat plate shape having a curved top portion, similarly to the first coupling portion 17, and projects inward in the facing direction from the inner surface of the second covering portion 20 in the facing direction. The second coupling portion 21 has the through hole 19 formed to extend therethrough along the widthwise direction.

In the second covering portion 20, a switch electrode 22, a switch 24, and an LED 25 as an example of an indicator light are provided.

The switch electrode 22 is formed of the same material as that of the second holding member 12 into a rod shape shorter than the second holding member 12. The switch electrode 22 is also inserted into the other longitudinal end portion of the second covering portion 20 to be spaced apart from the second holding member 12 in the longitudinal direction such that one longitudinal end portion thereof is covered with the other longitudinal end portion of the second covering portion 20 and the other longitudinal end portion thereof is exposed from the other longitudinal end portion of the second covering portion 20.

The switch 24 is a generally cylindrical push-button switch made of a conductive member of metal or the like and movable forward and backward in the facing direction. The switch 24 is provided to be biased by a biasing member such as a spring not shown to normally protrude (move forward) from the second covering portion 20 toward the opposite side of the second coupling portion 21. The switch 24 is also disposed on the other longitudinal end portion of the second covering portion 20 so as to face the other longitudinal end portion of the second holding member 12 and one longitudinal end portion of the switch electrode 22 in the facing direction.

The switch 24 is pressed toward the second covering portion 20 against the biasing force of a biasing member not shown to be moved backward into the second covering portion 20 (ON state). As a result, the switch 24 comes in contact with the other longitudinal end portion of the second holding member 12 and one longitudinal end portion of the switch electrode 22 so that the second holding member 12 and the switch electrode 22 are electrically connected to each other via the switch 24.

When the pressing toward the second covering portion 20 is removed, the switch 24 is moved forward from within the second covering portion 20 by the biasing force of the biasing member not shown (OFF state). As a result, the switch 24 moves away from the other longitudinal end portion of the second holding member 12 and one longitudinal end portion of the switch electrode 22 to cut off the electrical connection between the second holding member 12 and the switch electrode 22.

The LED 25 is disposed so as to face the other longitudinal end portion of the second holding member 12 in the facing direction and electrically connected to the other longitudinal end portion of the second holding member 12. The LED 25 constitutes a detection means in conjunction with the switch 24.

The first covering portion 16 and the second covering portion 20 are combined with each other by overlying the first coupling portion 17 and the second covering portion 21 on each other such that the respective through holes 19 of the first coupling portion 17 and the second coupling portion 21 overlap when projected in the widthwise direction.

Through each of the through holes 19, a rotating shaft 23 is inserted along the widthwise direction to be capable of relative rotation. Thus, each of the first holding member 11 and the second holding member 12 is supported rotatable around the rotating shaft 23. On the other hand, the first covering portion 16 and the second covering portion 20 are each biased by the biasing member not shown, such as a spring, to move one end portions of the first holding member 11 and the second holding member 12 closer to each other.

Note that the first holding member 11 and the second holding member 12 are controlled by a stopper not shown such that respective one end portions thereof face each other with a small gap left therebetween. Thus, one end portion of the first holding member 11 and one end portion of the second holding member 12 are normally insulated from each other.

On the other hand, the other end portion of the first holding member 11 and the other end portion of the second holding member 12 are insulated from each other by the supporting member 13.

That is, the first holding member 11 and the second holding member 12 are normally insulated from each other by the supporting member 13. When a conductor having a thickness larger than the foregoing small gap is inserted between one end portion of the first holding member 11 and one end portion of the second holding member 12, conduction is provided between the first holding member 11 and the second holding member 12.

In the attachment-side clip 2, when the other end portions of the first holding member 11 and the second holding member 12 are pressed inward in the facing direction against the biasing force of the biasing member not shown, the first holding member 11 and the second holding member 12 are rotated around the rotating shaft 23 so that one end portions of the first holding member 11 and the second holding member 12 are moved away from each other.

When the pressing of the other end portions of the first holding member 11 and the second holding member 12 is removed, by the biasing force of the biasing member not shown, the first holding member 11 and the second holding member 12 are rotated around the rotating shaft 23 so that one end portions of the first holding member 11 and the second holding member 12 are moved closer to each other.

The earth-side clip 3 is provided on the other end portion of the earth wire 1 (see FIG. 1).

As shown in FIG. 3, the earth-side clip 3 includes a first holding member 31, a second holding member 32 disposed to face the first holding member 31 in spaced-apart relation thereto, and a supporting member 33.

The first holding member 31 and the second holding member 32 are each formed of a conductive material such as metal into a rod shape (generally U-shape in cross section) extending in the longitudinal direction, similarly to the first holding member 11. The other longitudinal end portion of each of the first holding member 31 and the second holding member 32 has an indented non-slip portion 38 formed on the inner surface thereof in the facing direction thereof.

The supporting member 33 includes a first supporting member 34 and a second supporting member 35.

Each of the first supporting member 34 and the second supporting member 35 is made of an insulating resin and integrally includes a covering portion 36 and a coupling portion 37.

The covering portion 36 is formed in a generally cylindrical shape extending along the longitudinal direction, and one end portion of the first holding member 31 or the second holding member 32 is inserted in the covering portion 36 to extend therethrough. As a result, one end portion of the first holding member 31 or the second holding member 32 is covered with the covering portion 36.

The coupling portion 37 is formed in a generally triangular flat plate shape having a curved top portion and projects inward in the facing direction from the inner surface of the covering portion 36 in the facing direction. The coupling portion 37 has a through hole 39 formed to extend therethrough along the widthwise direction.

The first supporting member 34 and the second supporting member 35 are combined with each other by overlying the respective coupling portions 37 thereof on each other such that the respective through holes 39 thereof overlap when projected in the widthwise direction.

Through each of the through holes 39, a rotating shaft 40 is inserted along the widthwise direction to be capable of relative rotation. Thus, each of the first holding member 31 and the second holding member 32 is supported rotatable around the rotating shaft 40. On the other hand, the both covering portions 36 are biased by the biasing member not shown, such as a spring, to move the other end portions of the first holding member 31 and the second holding member 32 closer to each other.

Note that the first holding member 31 and the second holding member 32 are controlled by a stopper not shown such that the respective other end portions thereof face each other with a small gap left therebetween. Thus, the other end portion of the first holding member 31 and the other end portion of the second holding member 32 are normally insulated from each other.

On the other hand, one end portion of the first holding member 31 and one end portion of the second holding member 32 are insulated from each other by the supporting member 33.

That is, the first holding member 31 and the second holding member 32 are normally insulated from each other by the supporting member 33. When a conductor having a thickness larger than the foregoing small gap is inserted between the other end portion of the first holding member 31 and the other end portion of the second holding member 32, conduction is provided between the first holding member 31 and the second holding member 32.

In the earth-side clip 3, when one end portions of the first holding member 31 and the second holding member 32 are pressed inward in the facing direction against the biasing force of the biasing member not shown, the first holding member 31 and the second holding member 32 are rotated around the rotating shaft 40 so that the other end portions of the first holding member 31 and the second holding member 32 are moved away from each other.

When the pressing of one end portions of the first holding member 31 and the second holding member 32 is removed, by the biasing force of the biasing member not shown, the first holding member 31 and the second holding member 32 are rotated around the rotating shaft 40 so that the other end portions of the first holding member 31 and the second holding member 32 are moved closer to each other.

The earth-side wire 4 is an elongated conductive wire and formed by covering a wire made of metal such as copper with an insulator such as a resin.

The earth-side wire 4 has one end portion thereof connected to the other longitudinal end portion of the first holding member 11 of the attachment-side clip 2 and the other end portion thereof connected to one longitudinal end portion of the first holding member 31 of the earth-side clip 3.

The detection-side wire 5 is an elongated conductive wire similar to the earth-side wire 4 and formed by covering a wire made of metal such as copper with an insulator such as a resin.

The detection-side wire 5 has one end portion thereof connected to the other longitudinal end portion of the second holding member 12 of the attachment-side clip 2 and the other end portion thereof connected to one longitudinal end portion of the second holding member 32 of the earth-side clip 3. In the middle of the detection-side wire 5, a battery 41 as the power source of the LED 25 is provided.

In the in-use state of the earth wire 1, the attachment-side clip 2 is attached to the container C so as to hold a part of the container C between the first holding member 11 and the second holding member 12. That is, the first holding member 11 holds the container C from one side in the facing direction, while the second holding member 12 holds the container C from the other side in the facing direction.

On the other hand, the earth-side clip 3 is attached to the earth-potential member E so as to hold a part of the earth-potential member E between the first holding member 31 and the second holding member 32.

In this manner, the position of the attachment-side clip 2 is fixed to that of the container C, and the position of the earth-side clip 3 is fixed to that of the earth-potential member E.

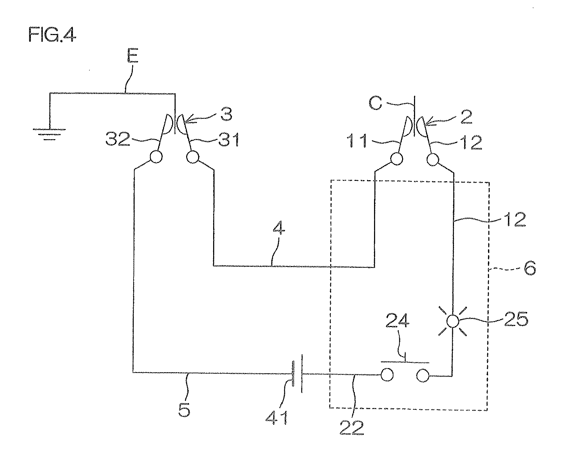

Next, referring to FIG. 4, a description is given of the function of the earth wire 1.

FIG. 4 is a circuit diagram for illustrating earthing by the earth wire shown in FIG. 1.

As shown in FIG. 4, the earth wire 1 in its in-use state forms, between the container C and the earth-potential member E, an earth-side line extending from the first holding member 11 of the attachment-side clip 2 and reaching the first holding member 31 of the earth-side clip 3 via the earth-side wire 4 and a detection-side line extending from the second holding member 32 of the earth-side clip 3 and reaching the second holding member 12 of the attachment-side clip 2 via the detection-side wire 5.

On the other hand, conduction is provided between the first holding member 11 and the second holding member 12 via the container C, while conduction is provided between the first holding member 31 and the second holding member 32 via the earth-potential member E.

Thus, between the container C and the earth-potential member E, a series circuit is formed which includes the attachment-side clip 2, the earth-side wire 4, the earth-side clip 3, and the detection-side wire 5.

Note that, since the switch 24 is normally in the OFF state, the detection-side line is not in conduction. Accordingly, the LED 25 is off.

To recognize conduction in the earth-side line, the switch 24 is turned ON. This ensures conduction in the detection-side line. As a result, a current flows from the battery 41 in the series circuit to turn on the LED 25.

In this manner, by turning on the LED 25, conduction in the earth-side line can be recognized.

Such an earth wire 1 includes the earth-side wire 4 and the detection-side wire 5 to which the switch 24 and the LED 25 are connected in a normally non-conducting state, and the earth-side wire 4 and the detection-side wire 5 are brought into conduction by attaching the attachment-side clip 2 to the container C and turning ON the switch 24.

Thus, the attachment of the attachment-side clip 2 to the container C and the turning ON of the switch 24 ensures conduction between the container C and the earth-side wire 4 and the detection-side wire 5.

In this manner, a series circuit is formed which extends from the detection-side wire 5 and successively passes through the container C and the earth-side wire 4 to reach the earth-side clip 3.

As a result, it is possible to detect conduction in the detection-side wire 5 from the turning on of the LED 25 based on the turning ON of the switch 24 and reliably detect that the container C is earthed by the earth-side wire 4.

With such an earth wire 1, the position of the attachment-side clip 2 is fixed to that of the container C by attaching the attachment-side clip 2 to the container C so as to hold the container C between the first holding member 11 and the second holding member 12.

Therefore, when the attachment-side clip 2 is attached to the container C, on both sides of substantially the same portion of the container C, the positions of the first holding member 11 and the second holding member 12 can be fixed.

In addition, the first holding member 11 and the second holding member 12 are normally insulated by the supporting member 13.

Accordingly, when the attachment-side clip 2 is attached to the container C, conduction is reliably provided between the first holding member 11 and the second holding member 12 via the container C.

As a result, it is possible to more reliably detect that the container C is earthed by the earth-side wire 4.

With such an earth wire 1, it is possible to allow the first holding member 11 to hold the container C from one side in the facing direction and allow the second holding member 12 to hold the container C from the other side in the facing direction.

Therefore, the container C can be reliably held between the first holding member 11 and the second holding member 12.

Also, with such an earth wire 1, conduction in the detection-side wire 5 can be easily recognized from the turning on of the LED 25.

Furthermore, with such an earth wire 1, since the switch 24 and the LED 25 are integrally provided with the device-side clip 2, operability can be improved.

Note that, in the embodiment described above, the switch 24 and the LED 25 are provided in the second supporting member 15 of the attachment-side clip 2, but the switch 24 and the LED 25 may also be provided in the detection-side wire 5.

Also, in the embodiment described above, the earth-side clip 3 is provided, but it may also be possible to directly connect the other end portions of the earth-side wire 4 and the detection-side wire 5 to the earth-potential member E without providing the earth-side clip 3.

Also, in the embodiment described above, the LED 25 is provided, but it may also be possible to provide a speaker in which a detection sound is stored as an example of a detection sound generator instead of or together with the LED 25.

Examples of the detection sound which can be used include a warning sound such as a beep and a voice announcement announcing the detection of conduction.

With such an earth wire 1, it is possible to recognize that the detection means has detected conduction in the detection-side wire 5 from the detection sound from the speaker.

While the foregoing invention is provided as the illustrative embodiments of the present invention, such is for illustrative purpose only and it is not to be construed limitative. Modification and variation of the present invention which will be obvious to those skilled in the art of the technical field is to be covered by the following claims.

### INDUSTRIAL APPLICABILITY

The earth device of the present invention is widely applicable to applications for preventing charging and releasing electric charge in various industrial fields such as a container for storing a volatile organic solvent and a device to which a high voltage is applied.

## Claims

1. An earth device for earthing an object to be earthed, comprising:
an earth-side wire;
a detection-side wire which is normally out of conduction with the earth-side wire;
an attachment member provided on one end portion of each of the earth-side wire and the detection-side wire and attached to the object to be earthed to provide conduction between the earth-side wire and the detection-side wire;
an earth member for earthing provided on the other end portion of each of the earth-side wire and the detection-side wire; and
a detection means connected to the detection-side wire to detect conduction in the detection-side wire.

2. An earth device according to Claim 1, wherein
the attachment member includes:
a first conductive member connected to one end portion of the earth-side wire;
a second conductive member connected to one end portion of the detection-side wire so as to be disposed to face the first conductive member in spaced-apart relation thereto and brought into conduction with the first conductive member when the attachment member is attached to the object to be earthed; and
an insulating member which normally provides insulation between the first conductive member and the second conductive member, and
the attachment member is attached to the object to be earthed so as to hold the object to be earthed between the first conductive member and the second conductive member to have a position thereof fixed to that of the object to be earthed.

3. An earth device according to Claim 2, wherein
the first conductive member is a first holding member for holding the object to be earthed from one side,
the second conductive member is a second holding member for holding the object to be earthed from the other side, and
the insulating member is a support member for supporting the first holding member and the second holding member rotatably around the same axis.

4. An earth device according to Claim 1, wherein the detection means includes an indicator light which is turned on upon detecting the conduction in the detection-side wire.

5. An earth device according to Claim 1, wherein the detection means includes a detection sound generator for generating a detection sound upon detecting the conduction in the detection-side wire.
